## Europäisches Patentamt

## European Patent Office

## Office européen des brevets

(19)

(11) Veröffentlichungsnummer: **0 103 181 B1**

(12) **EUROPÄISCHE PATENTSCHRIFT**

(45) Veröffentlichungstag der Patentschrift:
07.01.88

(21) Anmeldenummer: 83107969.4

(22) Anmeldetag: 11.08.83

(51) Int. Cl.⁴: **H 01 L 29/743**

(54) Thyristor mit anschaltbaren Stromquellen.

(30) Priorität: 18.08.82 DE 3230721

(43) Veröffentlichungstag der Anmeldung:
21.03.84 Patentblatt 84/12

(45) Bekanntmachung des Hinweises auf die Patenterteilung:
07.01.88 Patentblatt 88/1

(84) Benannte Vertragsstaaten:
CH DE FR GB LI NL SE

(56) Entgegenhaltungen:
US - A - 3 284 639
US - A - 3 307 049
US - A - 4 286 279

(73) Patentinhaber: Siemens Aktiengesellschaft Berlin und München, Wittelsbacherplatz 2, D-8000 München 2 (DE)

(72) Erfinder: Patalong, Hubert, Dr. Ing. Dipl.-Phys., Kurt-Flöricke-strasse 18, D-8000 München 60 (DE)
Erfinder: Spenke, Eberhard, Dr. phil, Siemens Strasse 1, D-8551 Pretzfeld (DE)

## Beschreibung

Die Erfindung bezieht sich auf einen Thyristor nach dem Oberbegriff des Patentanspruchs 1.

Ein Thyristor dieser Art ist aus der US-A-3 307 049 bekannt. Dabei bestehen die anschaltbaren Stromquellen jeweils aus einem im Sekundärkreis eines Transformators liegenden Zweiweggleichrichter, aus einer im Primärkreis des Transformators liegenden Wechselspannungsquelle und aus einem Schalter, der über einen ohmschen Widerstand mit dem Zweiweggleichrichter verbunden ist.

Im blockierten Zustand eines Thyristors ist von seinen pn-Übergängen nur der die beiden Basisschichten voneinander trennende, mittlere pn-Übergang in Sperrichtung gepolt, so dass praktisch die gesamte anliegende Spannung an ihm abfällt. Die positiven Defektelektronen sind hierbei aus dem an den Übergang angrenzenden Teil der p-Basis verdrängt. Gleichzeitig sind die negativen Elektronen aus dem angrenzenden Teil der n-Basis verdrängt. Die unbeweglichen Akzeptoren und Donatoren der Dotierung ergeben somit eine Raumladungszone am mittleren pn-Übergang. Von der anliegenden Spannung fallen nur zu vernachlässigende Teile an den pn-Übergängen zwischen den Emittern und den jeweils angrenzenden Basisschichten ab, so dass aus den Emittern keine Emission in die Basisschichten stattfindet.

Werden aus dem n-Emitter Elektronen und aus dem p-Emitter Defektelektronen in die jeweils angrenzenden Basisschichten injiziert, so bauen diese die genannte Raumladungszone immer mehr ab. In dem Masse, wie das geschieht, wird die blockierende Wirkung des mittleren pn-Übergangs aufgehoben. Dadurch werden die an den übrigen pn-Übergängen abfallenden Teile der anliegenden Spannung grösser und verstärken die Emission der Emitter. Schliesslich überschwemmen die injizierten Ladungsträger als quasineutrales Plasma die beiden Basisschichten und den mittleren pn-Übergang. Danach fällt an keinem der pn-Übergänge mehr eine nennenswerte Spannung ab, der Thyristor ist voll durchgezündet und führt nun einen Laststrom, der im wesentlichen durch einen äusseren Stromkreis (Lastkreis) und den in diesem befindlichen Lastwiderstand bestimmt ist.

Handelt es sich bei dem äusseren Stromkreis um einen Wechselstromkreis, so wird der Thyristor beim nächstfolgenden Nulldurchgang der anliegenden Spannung gelöscht. Handelt es sich dagegen um einen Gleichstromkreis oder soll der Thyristor in einem Wechselstromkreis noch vor dem Erreichen des Nulldurchgangs gelöscht werden, so muss der blockierte Zustand wiederhergestellt werden, was durch Beseitigung des den mittleren pn-Übergang überschwemmenden Elektronen-Defektelektronen-Plasmas geschieht.

Bei einem im blockierten Zustand befindlichen Thyristor werden durch die Anschaltung der ersten und zweiten Stromquelle an die dritte und vierte Elektrode zwei Injektionsstromquellen wirksam, von denen die eine Defektelektronen und die andere Elektronen in die beiden Basisschichten injiziert. Die von beiden Stromquellen injizierten Ladungsträger verursachen zwei gleichzeitig ablaufende und sich ergänzende Auffüllvorgänge, durch die die Raumladungszone am mittleren pn-Übergang sehr rasch und wirkungsvoll mit Ladungsträgern aufgefüllt wird, so dass der Thyristor sicher zündet. Andererseits wird das im Durchlasszustand des Thyristors den mittleren pn-Übergang überschwemmende Elektronen-Defektelektronen-Plasma durch das Anschalten zweier als Extraktionsstromquellen gepolter Stromquellen an die dritte und vierte Elektrode aus dem Thyristor in sehr wirkungsvoller Weise herausgesaugt, so dass der Thyristor rasch gelöscht wird.

Nachteilig ist bei dem oben beschriebenen bekannten Thyristor, dass die anschaltbaren Spannungsquellen den erforderlichen Schaltungsaufwand stark erhöhen und zwischen den Primär- und Sekundärseiten der Transformatoren beträchtliche Potentialunterschiede liegen können, wenn der Thyristor in einem Laststromkreis liegt, über den er mit einem hohen Anodenpotential und ggf. auch mit einem hohen Kathodenpotential beaufschlagt wird.

Der Erfindung liegt die Aufgabe zugrunde, einen Thyristor nach dem Oberbegriff des Patentanspruchs 1 anzugeben, der schnell und wirkungsvoll gezündet oder gelöscht werden kann, ohne dass dabei die vorstehend beschriebenen Nachteile auftreten. Das wird erfindungsgemäss durch eine Ausbildung nach dem kennzeichnenden Teil des Patentanspruchs 1 erreicht.

Die Ansprüche 2 bis 4 sind auf bevorzugte Ausgestaltungen und Weiterbildungen der Erfindung gerichtet.

Die Erfindung wird nachfolgend anhand der Zeichnung näher erläutert. Dabei zeigt:

Fig. 1 einen bekannten Thyristor mit zwei Injektionsstromquellen,

Fig. 2 einen bekannten Thyristor mit zwei Extraktionsstromquellen,

Fig. 3 einen bekannten Thyristor mit zwei Injektions- und zwei Extraktionsstromquellen,

Fig. 4 ein erstes Ausführungsbeispiel der Erfindung,

Fig. 5 ein zweites Ausführungsbeispiel und

Fig. 6 ein drittes Ausführungsbeispiel der Erfindung, bei dem die vorgesehenen anschaltbaren Stromquellen entsprechend den Fig. 1 bis 3 in prinzipieller Weise dargestellt sind.

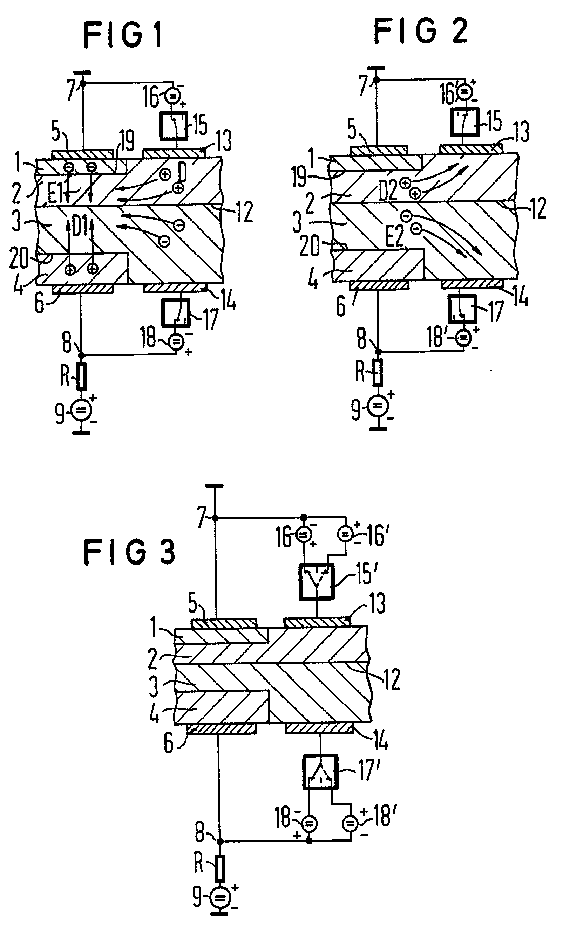

In Fig. 1 ist ein bekannter Thyristor mit einem Halbleiterkörper aus dotiertem Halbleitermaterial, z.B. Silizium, dargestellt, der vier aufeinanderfolgende Schichten abwechselnder Leitungstypen aufweist. Bei diesen handelt es sich um den n-Emitter 1, die p-Basis 2, die n-Basis 3 und den p-Emitter 4. Der n-Emitter 1 ist mit einer kathodenseitigen Elektrode 5 versehen, der p-Emitter 4 mit einer anodenseitigen Elektrode 6, wobei die Elektroden aus einem elektrisch leitenden Material, z.B. Aluminium, bestehen. Die Elektrode 5 ist über einen Anschluss 7 mit Masse verbunden, die Elektrode 6 über einen Anschluss 8 und einen Lastwiderstand R mit dem oberen Anschluss einer Spannungsquelle 9, deren unterer Anschluss auf Masse liegt.

Die p-Basis 2 wird von einer Elektrode 13 und die n-Basis 3 von einer Elektrode 14 aus elektrisch leitendem Material, z.B. Aluminium, kontaktiert. Dabei ist die Elektrode 13 über einen Schalter 15 und eine Stromquelle 16 mit dem Anschluss 7 der kathodenseitigen Elektrode 5 verbunden, die Elektrode 14 über einen Schalter 17 und eine Stromquelle 18 mit dem Anschluss 8 der anodenseitigen Elektrode. Die Stromquellen 16 und 18 weisen eine solche Polarität auf, dass sie in der gezeigten Stellung der Schalter 15 und 17 die Elektrode 13 positiv gegenüber der kathodenseitigen Elektrode 5 und die Elektrode 14 negativ gegenüber der anodenseitigen Elektrode 6 vorspannen.

Im blockierten Zustand des Thyristors liegt der Anodenanschluss 8 auf positivem Potential, sodass der pn-Übergang 12 zwischen der p-Basis und der n-Basis in Sperrichtung gepolt ist, wobei praktisch die gesamte zwischen 7 und 8 anliegende Spannung an diesem Übergang abfällt. An den pn-Übergängen 19 und 20 fallen dagegen nur zu vernachlässigende Teile dieser Spannung ab, so dass keine Emission aus den Emittern 1 und 4 in die Basisschichten 2 und 3 erfolgt. In den an den Übergang 12 angrenzenden Teilen der p-Basis 2 und der n-Basis 3 ist eine Raumladungszone vorhanden. Die Schalter 15 und 17 trennen dabei die Stromquellen 16 und 18 von den Elektroden 13 und 14 ab.

Bringt man die Schalter 15 und 17 in die gezeichnete Stellung, so werden Elektronen E1 vom n-Emitter 1 in die p-Basis 2 injiziert. Gleichzeitig werden Defektelektronen D1 aus dem p-Emitter 4 in die n-Basis 3 injiziert. Die blockierende Wirkung des Übergangs 12 wird hierdurch immer mehr reduziert, so dass immer grössere Teile der zwischen 7 und 8 anliegenden Spannung an den pn-Übergängen 19 und 20 abfallen und die Emission aus den Emittern verstärken bzw. aufrechterhalten. Die aus dem n-Emitter 1 in die p-Basis 2 injizierten Elektronen E1 und die aus dem p-Emitter 4 in die n-Basis 3 injizierten Defektelektronen D1 bilden sodann ein Elektronen-Defektelektronen-Plasma, das die Basisschichten 2 und 3 überschwemmt. Damit ist der Thyristor voll durchgezündet und befindet sich im leitenden Zustand. Gelöscht wird er z.B. durch eine Unterbrechung des bei 7 und 8 angeschlossenen, äusseren Stromkreises oder bei einer Wechselspannungsquelle 9 automatisch beim Erreichen des nächstfolgenden Nulldurchgangs der zwischen 7 und 8 anliegenden Spannung. Die Schalter 15 und 17 werden zweckmässigerweise nach dem Zünden des Thyristors wieder geöffnet, so dass die Stromquellen 16 und 17 abgeschaltet sind.

Fig. 2 zeigt einen anderen bekannten Thyristor, der weitgehend gemäss Fig. 1 aufgebaut ist. An die Stelle der Stromquellen 16 und 18 treten lediglich Stromquellen 16' und 18' entgegengesetzter Polarität.

Der Thyristor nach Fig. 2 wird, was in der Zeichnung im einzelnen nicht dargestellt ist, durch Zuführung eines positiven Zündstromimpulses an die Elektrode 13 gezündet. Im leitenden Zustand des Thyristors befinden sich die Schalter 15 und 16 in den nicht gezeichneten Schaltstellungen, in denen die Stromquellen 16' und 18' abgeschaltet sind. Soll nun der Thyristor gelöscht werden, so werden die Stromquellen 16' und 18' über 15 und 17 an die Elektroden 13 und 14 geschaltet. Hierdurch wird das den Übergang 12 und die Basisschichten 2 und 3 überschwemmende Elektronen-Defektelektronen-Plasma in besonders wirkungsvoller Weise aus den Basisschichten 2, 3 herausgesaugt. Im einzelnen gelangen dabei die Elektronen E2 des Plasmas zur Elektrode 14 und die Defektelektronen D2 des Plasmas zur Elektrode 13. In dem Masse, in dem die Ladungsträgerkonzentration im Plasma abgesenkt wird, verliert dieses seine Leitfähigkeit, der Widerstand des Thyristors steigt, der Laststrom durch die Anschlüsse 7, 8 sinkt, der Spannungsabfall im Lastwiderstand R wird geringer und die Spannung der Spannungsquelle 9 wird immer mehr von der Thyristorstruktur 1 bis 4 und schliesslich von der Raumladungszone beiderseits des Übergangs 12 übernommen. Damit befindet sich der Thyristor im blockierten Zustand. Das Löschen des Transistors erfolgt also gemäss Fig. 2 ohne eine Unterbrechung des bei 7 und 8 angeschlossenen Stromkreises bzw. ohne eine Kompensation der Spannungsquelle 9.

Fig. 3 zeigt einen bekannten Thyristor mit einem den Figuren 1 bzw. 2 entsprechenden Aufbau, bei dem die Elektrode 13 über einen Umschalter 15' wahlweise mit dem positiven Pol einer Stromquelle 16 oder dem negativen Pol einer Stromquelle 16' beschaltbar ist, die mit ihren anderen Polen jeweils mit dem Anschluss 7 verbunden sind. Die Elektrode 14 ist über einen Umschalter 17' wahlweise mit dem negativen Pol einer Stromquelle 18 und dem positiven Pol einer Stromquelle 18' beschaltbar, die mit ihren anderen Polen jeweils mit dem Anschluss 8 verbunden sind. Befindet sich der Thyristor nach Fig. 3 in blockiertem Zustand, so wird er durch eine Betätigung der Umschalter 15' und 17', durch die diese aus den mittleren Schaltstellungen in die ausgezogenen Schaltstellungen gelangen, gezündet, wobei der Zündvorgang so abläuft, wie dies bereits anhand von Fig. 1 beschrieben wurde. Im leitenden Zustand des Thyristors werden die Umschalter 15' und 17' in ihre mittleren Schaltstellungen zurückgebracht, in der die Stromquellen 16, 16', 18 und 18' von den Elektroden 13, 14, abgeschaltet sind. Zum Löschen des Thyristors werden 15' und 17' in die gestrichelt gezeichneten Schaltstellungen gebracht, wobei der Löschvorgang so abläuft, wie dies bereits anhand von Fig. 2 beschrieben wurde.

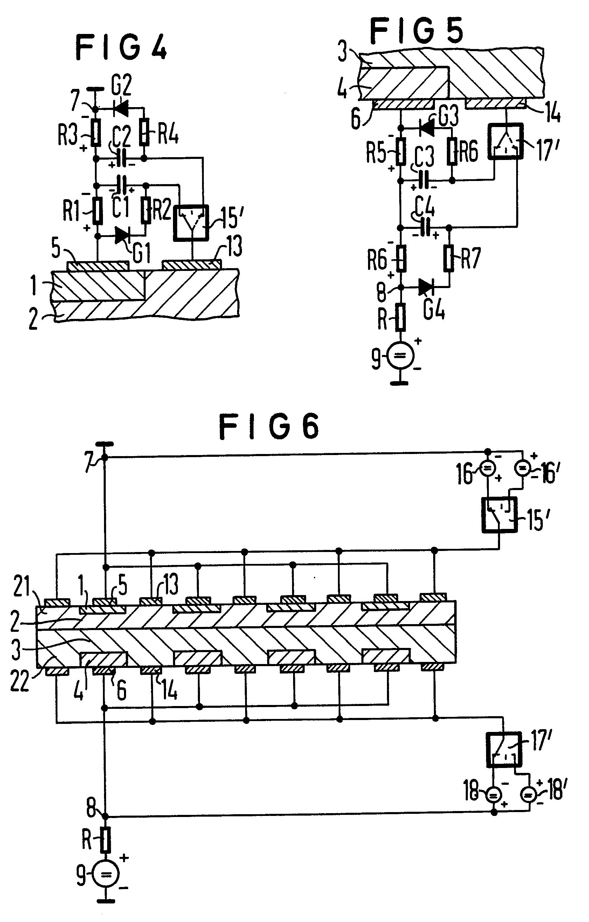

In Fig. 4 ist nun ein vorteilhaftes Ausführungsbeispiel der Erfindung dargestellt, das von der Prinzipschaltung nach Fig. 3 ausgeht. Die Stromquelle 16 wird hierbei durch eine Kapazität C1 nachgebildet, die mit dem Umschalter 15' und mit dem von der Elektrode 5 abgewandten Ende eines in die Zuleitung vom Anschluss 7 zur Elektrode 5 eingefügten Widerstandes R1 verbunden ist. Parallel zu der Serienschaltung R1, C1 liegt ein Gleichrichter G1, wobei zweckmässigerweise in Serie zu G1 ein Strombegrenzungswiderstand R2 eingefügt ist. Die Stromquelle 16' wird durch eine Kapazität C2 nachgebildet, die mit dem Umschalter 15' und mit dem der Elektrode 5 zugewandten Ende eines in die genannte Zuleitung eingefügten Widerstandes R3 verbunden ist. Parallel zu der Serienschaltung R3, C2 liegt ein Gleichrichter G2, wobei zweckmässigerweise in Serie zu G2 ein Strombegrenzungswiderstand R4 vorgesehen ist. Im leitenden Zustand des Thyristors treten an den Widerständen R1 und R3 jeweils Spannungsabfälle auf, deren Polaritäten in Fig. 4 angedeutet sind. Über die Gleichrichter G1 und G2 werden die Kapazitäten C1 und C2 mit Spannungen aufgeladen, deren Polaritäten ebenfalls eingezeichnet sind. Wie hieraus hervorgeht, ist der mit dem Umschalter 15' verbundene Anschluss von C1 gegenüber seinem mit R1 verbundenen Anschluss positiv vorgespannt, während der mit dem Schalter 15' verbundene Anschluss von C2 gegenüber seinem mit R3 verbundenen Anschluss negativ vorgespannt ist.

Fig. 5 erläutert eine weiteres vorteilhaftes Ausführungsbeispiel der Erfindung, das von der Prinzipschaltung nach Fig. 3 ausgeht. Hier wird die Stromquelle 18 durch eine Kapazität C3 nachgebildet, die mit dem Umschalter 17' und mit dem von der Elektrode 6 abgewandten Ende eines in die Zuleitung vom Anschluss 8 zur Elektrode 6 eingefügten Widerstandes R5 verbunden ist. Parallel zu der Serienschaltung R5, C3 liegt ein Gleichrichter G3, wobei zweckmässigerweise ein Strombegrenzungswiderstand R6 in Serie zu G3 vorgesehen ist. Die Stromquelle 18' von Fig. 3 wird durch eine Kapazität C4 nachgebildet, die mit dem Umschalter 17' und dem der Elektrode 8 zugewandten Ende eines in die zuletzt genannte Zuleitung eingefügten Widerstandes R6 verbunden ist. Parallel zu der Serienschaltung R6, C4 liegt ein Gleichrichter G4, wobei zweckmässigerweise in Serie zu G4 ein Strombegrenzungswiderstand R7 angeordnet ist. Die Wirkungsweise der Schaltung nach Fig. 5 entspricht der der korrespondierenden Teilschaltung nach Fig. 4.

Fig. 6 zeigt eine Halbleiteranordnung, bei der eine Mehrzahl von Thyristoren, die jeweils entsprechend Fig. 3 angedeutet sind und nach den Fig. 4 und/oder 5 ausgebildet sind, auf einem gemeinsamen Halbleiterkörper integriert sind. Einer dieser Thyristoren ist mit den gleichen Bezugszeichen versehen wie in Fig. 3, während die anderen mit ihren Elektroden den Elektroden 5, 6, 13 und 14 des ersteren parallel geschaltet sind. Es ergibt sich eine Halbleiteranordnung, in der sich jeweils streifenförmige Thyristorstrukturen, z.B. 1 bis 4, und pn-Strukturen, z.B. 2 und 3, die jeweils mit einer dritten Elektrode, z.B. 13, und einer dieser gegenüberliegenden vierten Elektrode, z.B. 14, versehen sind, miteinander abwechseln. Aus Symmetriegründen kann, wie in Fig. 6 dargestellt, auch linksseitig von der Thyristorstruktur 1 bis 4 eine weitere pn-Struktur 21, 22 vorgesehen sein.

**Patentansprüche**

1. Thyristor mit einem Halbleiterkörper, der einen von einer ersten Elektrode (5) kontaktierten n-Emitter (1) mit einer angrenzenden p-Basisschicht (2) und einen von einer zweiten Elektrode (6) kontaktierten p-Emitter (4) mit einer angrenzenden n-Basisschicht (3) aufweist, wobei die Basisschichten (23) durch einen pn-Übergang (12) voneinander getrennt sind, bei dem die p-Basisschicht (2) mit einer dritten Elektrode (13) versehen ist, die über eine erste, mit einer ersten Polarität anschaltbare Stromquelle (16, 16') mit der ersten Elektrode (5) verbunden ist, und bei dem die n-Basisschicht (3) mit einer vierten Elektrode (14) versehen ist, die über eine zweite anschaltbare Stromquelle (18, 18'), die mit einer zu der ersten entgegengesetzten Polarität anschaltbar ist, mit der zweiten Elektrode (6) verbunden ist, dadurch gekennzeichnet, dass wenigstens eine der anschaltbaren Stromquellen von der Serienschaltung eines Schalters (15') und eines Kondensators (C1, C2) gebildet wird, die einerseits mit einem Anschluss eines in die Zuleitung zur ersten (5) oder zweiten Elektrode eingefügten Widerstandes (R1, R3) und andererseits mit der dritten (13) oder vierten Elektrode verbunden ist, und dass dem Kondensator und dem eingefügten Widerstand (C1, R1; C2, R3) ein Gleichrichter (G1, G2) parallel geschaltet ist.

2. Thyristor nach Anspruch 1, dadurch gekennzeichnet, dass ein Strombegrenzungswiderstand (R2, R4) in Serie zum Gleichrichter (G1, G2) vorgesehen ist.

3. Thyristor nach einem der Ansprüche 1 oder 2, dadurch gekennzeichnet, dass die dritte und vierte Elektrode (13, 14) jeweils zwischen zwei mit entgegengesetzter Polarität anschaltbaren Stromquellen (16, 16', 18, 18') umschaltbar sind.

4. Halbleiteranordnung mit einer Mehrzahl von Thyristoren nach einem der vorhergehenden Ansprüche, dadurch gekennzeichnet, dass die einzelnen Thyristoren (1 bis 4) und die diesen zugeordneten an einander gegenüberliegenden Grenzflächen derselben vorgesehenen, sich jeweils gegenüberliegenden dritten und vierten Elektroden (13, 14) derart auf einem Halbleiterkörper integriert sind, dass sie auf diesem in abwechselnder Folge nebeneinander angeordnet sind.

**Claims**

1. A thyristor comprising a semiconductor body provided with a n-emitter (1) which is contacted by a first electrode (5) and is adjoined by a p-base layer (2), and a p-emitter (4) which is contacted by a second electrode (6) and is adjoined by an n-base layer (3), the base layers (2, 3) being separated from one another by a pn-junction (12), the p-base layer (2) being provided with a third electrode (13) which is connected to the first electrode (5) through a first current source (16, 16') which can be connected with a first polarity, and the n-base layer (3) being provided with a fourth electrode (14) which is connected to the second electrode (6) through a second current source (18, 18′) which can be connected with a polarity which is opposite to the first polarity, characterised in that at least one of the connectible current sources is formed by the series arrangement of a switch (15′) and a capacitor (C1, C2), which arrangement is connected, on the one hand, to a terminal of a resistor (R1, R3) which is inserted into the supply line to the first electrode (5) or the second electrode, and, on the other hand, to the third electrode (13) or fourth electrode; and that a rectifier (G1, G2) is connected in parallel with the capacitor and the inserted resistor (C1, R1; C2, R3).

2. A thyristor as claimed in Claim 1, characterised in that a current-limiting resistor (R2, R4) is arranged in series with the rectifier (G1, G2).

3. A thyristor as claimed in one of Claims 1 or 2, characterised in that the third and fourth electrodes (13, 14) can in each case be switched over between two current sources (16, 16′, 18, 18′) which can be connected with opposite polarities.

4. A semiconductor arrangement comprising a plurality of thyristors as claimed in one of the preceding Claims, characterised in that the individual thyristors (1 to 4) and the third and fourth electrodes (13, 14) which are assigned to said thyristors, and are in each case arranged on opposite boundary surfaces thereof in opposition to one another, are integrated onto a semiconductor component in such manner that they are arranged one beside another in alternating sequence on said semiconductor component.

**Description**

1. Thyristor, comprenant un corps semi-conducteur qui présente un émetteur n (1) en contact avec une première électrode (5) et voisine d'une couche de base p (2) ainsi qu'un émetteur p (4) en contact avec une deuxième électrode (6) et voisine d'une couche de base n (3), les couches de base (2, 3) étant séparées l'une de l'autre par une jonction pn (12), la couche de base p (2) étant pourvue d'une troisième électrode (13) reliée à la première électrode (5) à travers une première source de courant (16, 16′) connectable avec une première polarité, et la couche de base n (3) étant pourvue d'une troisième électrode (14) reliée à la deuxième électrode (6) à travers une seconde source de courant (18, 18′) connectable avec une polarité contraire à la première polarité, caractérisé en ce que l'une au moins des sources de courant connectables est formée par le montage en série d'un interrupteur (15′) et d'un condensateur (C1, C2), montage en série qui est relié d'un côté à une borne d'une résistance (R1, R3) insérée dans la connexion ménant à la première (5) ou à la deuxième électrode et, de l'autre côté, à la troisième (13) ou la quatrième électrode, et qu'un redresseur (G1, G2) est monté en parallèle avec le condensateur et la résistance insérée (C1, R1; C2, R3).

2. Thyristor selon la revendication 1, caractérisé en ce qu'une résistance de limitation du courant (R2, R4) est prévue en série avec le redresseur (G1, G2).

3. Thyristor selon la revendication 1 ou 2, caractérisé en ce que les troisièmes et quatrièmes électrodes (13, 14) peuvent être reliées sélectivement à deux sources de courant (16, 16′, 18, 18′), connectables avec des polarités contraires.

4. Dispositif semi-conducteur comportant un certain nombre de thyristors selon une des revendications précédentes, caractérisé en ce que les différents thyristors (1 à 4) et les troisièmes et quatrièmes électrodes (13, 14) coordonnées à ces thyristors et qui sont prévues sur des surfaces limites mutuellement opposées de ceux-ci, de manière qu'une troisième électrode se trouve chaque fois en face d'une quatrième électrode, sont intégrés sur un corps semi-conducteur en étant juxtaposés dans une disposition alternante.

FIG 1

FIG 2

FIG 3

FIG 4

FIG 5

FIG 6